# EUROPÄISCHE PATENTANMELDUNG

(11) **EP 1 052 780 A2**
(43) Veröffentlichungstag der Anmeldung: **15.11.2000**
(21) Anmeldenummer: 00109446.5
(22) Anmeldetag: 03.05.2000
(51) Int. Cl.: H03M 1/08, H03M 3/02

(54) **Integrierter Schaltkreis mit einem A/D- oder D/A-Wandler mit galvanischer Trennung**

(30) Priorität: 12.05.1999 DE 19922127
(71) Anmelder: SIEMENS AKTIENGESELLSCHAFT, 80333 München (DE)
(72) Erfinder: Munz, Dieter, Dipl.-Ing. (FH), 91315 Höchstadt (DE); Günther, Harald, Dipl.-Ing., 90537 Feucht (DE); Staudt, Michael, Dipl.-Ing. (FH), 90469 Nürnberg (DE); Thamm, Peter, Dr., 76227 Karlsruhe (DE)

(57) **Zusammenfassung**

Die Erfindung betrifft einen integrierten Schaltkreis, welcher einen Analog/Digital-Umsetzer oder einen Digital/Analog-Umsetzer sowie einen mit diesem verbundenen analogen und einen digitalen Signalpfad enthält. Im digitalen Signalpfad des integrierten Schaltkreises ist weiterhin eine Vorrichtung zur Potentialtrennung vorgesehen.

## Beschreibung

Die Erfindung betrifft einen integrierten Schaltkreis, welcher einen Analog/Digital-Umsetzer oder einen Digital/Analog-Umsetzer sowie einen mit diesem verbundenen analogen und einen digitalen Signalpfad enthält.

Aus dem vom R. Oldenbourg Verlag München Wien 1988 herausgegebenen Buch 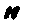 Digitale Verarbeitung analoger Signale" von Samuel D. Stearns, 4. Auflage, Seiten 69 bis 75, sind bereits A/D-Wandler und D/A-Wandler bekannt. Ein A/D-Wandler digitalisiert die Abtastwerte einer vorliegenden Zeitfunktion und liefert die Eingangssignale für einen digitalen Prozessor. Ein D/A-Wandler arbeitet reziprok zu dem A/D-Wandler. Er wandelt einen kodierten Satz von digitalen Werten in eine sich ändernde analoge Spannung um. Bei der A/D-Wandlung können Quantisierungsfehler, Nachziehfehler und Zitterfehler auftreten, die die Genauigkeit der Umwandlung beeinträchtigen. Die Auswirkungen verschiedener elektrischer oder mechanischer Fehlerquellen in D/A-Wandlern versucht man dadurch gering zu halten, daß man Präzisionsbauteile auswählt, Präzisionsstromversorgungen benutzt, den Betriebstemperaturbereich verkleinert, usw.

Weiterhin sind A/D-Wandler und D/A-Wandler auch aus dem vom Springer Verlag 1990 herausgegebenen Buch 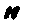 Halbleiter-Schaltungstechnik" von U. Tietze und Ch. Schenk, Seiten 751 bis 790, bekannt. Eine Realisierung eines derartigen Wandlers kann unter Verwendung des Parallelverfahrens, des Wägeverfahrens und des Zählverfahrens vorgenommen werden. Die genannten Wandler werden in der Regel als integrierte Schaltungen angeboten, beispielsweise C-MOS-Schaltungen.

Bei derartigen A/D- und D/A-Wandlern sind die Analog- und die Digitalseite jeweils auf unterschiedliche Referenzpotentiale bezogen, so daß Potentialunterschiede auftreten. Diese müssen auf geeignete Weise kompensiert werden. Dies geschieht bisher dadurch, daß die Datenkanäle von Wandlerbausteinen durch vor oder nach dem Wandlerbaustein angeordnete diskrete Bauteile potentialgetrennt werden. Für eine derartige galvanische Trennung werden Optokoppler, induktive oder kapazitive Kopplungen verwendet.

Aus der DE-197 18 420 A1 ist bereits eine integrierte Datenübertragungsschaltung mit Potentialtrennung zwischen Ein- und Ausgangsschaltkreis bekannt. Dieser werden eingangsseitig binäre Eingangssignale zugeführt, die unter Verwendung eines innerhalb der integrierten Datenübertragungsschaltung angeordneten magnetosensitiven Koppelelementes übertragen und am Ausgang der integrierten Datenübertragungsschaltung als binäre Ausgangssignale zur Verfügung gestellt werden.

Die Aufgabe der Erfindung besteht darin, einen in Form eines integrierten Schaltkreises realisierten Analog/Digital-Wandler oder Digital/Analog-Wandler derart weiterzubilden, daß die Gesamtschaltung, innerhalb derer er angeordnet ist, einen verringerten Stromverbrauch aufweist.

Diese Aufgabe wird durch einen integrierten Schaltkreis mit den im Anspruch 1 angegebenen Merkmalen gelöst. Vorteilhafte Ausgestaltungen und Weiterbildungen der Erfindung ergeben sich aus den abhängigen Ansprüchen.

Die Vorteile der Erfindung bestehen insbesondere darin, daß ein als integrierter Schaltkreis realisierter A/D-Wandler oder D/A-Wandler mit den erfindungsgemäßen Merkmalen durch die Integration der Vorrichtung zur Potentialtrennung in den innerhalb der integrierten Schaltung vorgesehenen digitalen Signalpfad wesentlich weniger Energie verbraucht als ein Wandler mit vor- oder nachgeschalteter, mittels diskreter Bauelemente realisierter Potentialtrennung. Darüber hinaus benötigt ein Wandler gemäß der Erfindung bei seiner Realisierung weniger Fläche, was eine Miniaturisierung von A/D- bzw. D/A-Wandlern begünstigt. Weiterhin werden mittels eines derartigen Wandlers höhere Datenraten erzielt. Ferner sind derartige Wandler auch kostengünstiger zu realisieren als bekannte Wandler. Durch die Erfindung wird eine neue Klasse von Bauelementen zur Verfügung gestellt, welche die Funktionen eines A/D- bzw. D/A-Wandlers und einer berührungsfreien Datenübertragungsschaltung in sich vereinigen. Dieses Prinzip läßt sich auf alle gängigen A/D- und D/A-Wandler anwenden.

Weitere vorteilhafte Eigenschaften der Erfindung ergeben sich anhand von Ausführungsbeispielen, die nachfolgend anhand der Figuren näher erläutert werden. Es zeigt:
- Figur 1: ein Blockschaltbild eines integrierten Schaltkreises, welcher einen Analog/Digital-Wandler enthält,
- Figur 2: ein Blockschaltbild eines integrierten SchaltKreises, welcher einen Digital/Analog-Wandler enthält, und
- Figur 3: ein Bockschaltbild eines integrierten Schaltkreises, welcher als Analog/Digital-Wandler einen Sigma-Delta-Wandler enthält.

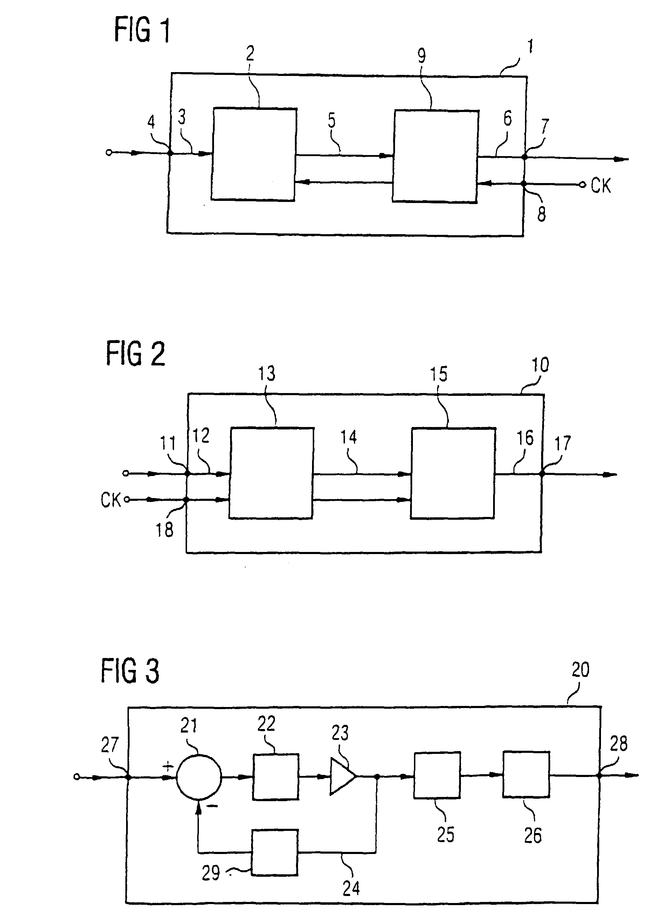

Die Figur 1 zeigt ein Blockschaltbild eines integrierten Schaltkreises 1, welcher einen Analog/Digital-Wandler 2 enthält. Dem Eingang 4 des integrierten Schaltkreises 1 wird das zu wandelnde analoge Signal zugeführt, welches dann vom Eingang 4 des integrierten Schaltkreises 1 aus über einen analogen Signalpfad 3 dem Analog/Digital-Wandler 2 zugeführt wird. Dieser stellt an seinem Ausgang ein digitale Werte aufweisendes digitales Signal zur Verfügung, welches über einen digitalen Signalpfad 5, 6 an den Ausgang 7 des integrierten Schaltkreises 1 weitergeleitet wird.

Im digitalen Signalpfad 5, 6 ist eine Vorrichtung 9 zur Potentialtrennung vorgesehen, die folglich dem Analog/Digital-Wandler 2 nachgeschaltet ist. Die Vorrichtung zur Potentialtrennung weist eingangsseitig eine Leiterschleife auf, über welche das in digitaler Form vorliegende Signal geführt wird. Durch dieses digitale Signal wird im Umgebungsbereich der Leiterschleife ein Magnetfeld erzeugt, welches sich in Abhängigkeit vom digitalen Signal ändert. Dieses sich ändernde Magnetfeld wird von einem Magnetfelddetektor erkannt, der durch einen Isolator von der Leiterschleife getrennt angeordnet ist, sich aber im Bereich des genannten Magnetfeldes befindet. Das vom Magnetfelddetektor detektierte Signal wird als galvanisch von der Eingangsseite getrenntes digitales Signal am Ausgang 7 des integrierten Schaltkreises 1 zur Verfügung gestellt.

Innerhalb des Analog/Digital-Wandlers 2 wird ein digitales Taktsignal benötigt. Dieses wird dem integrierten Schaltkreis über einen Eingang 8 zugeführt und über die Vorrichtung 9 zur Potentialtrennung an den Analog/Digital-Wandler 2 weitergeleitet. Dadurch entstehen innerhalb der Vorrichtung 9 zur Potentialtrennung zwei Übertragungskanäle, von denen einer ein Datenübertragungskanal und der andere ein Taktübertragungskanal ist.

Der Magnetfelddetektor der Vorrichtung 9 zur Potentialtrennung kann in Form eines Hallelementes realisiert sein. Weiterhin kann es sich bei dem genannten Magnetfelddetektor auch um einen AMR-Sensor handeln (anisotropic magnetic resistance), der auf ein sich änderndes magnetischer Feld mit einer Widerstandsveränderung reagiert. Derartige AMR-Sensoren weisen einen Permalloyschicht auf.

Zur Verbesserung der Sensitivität des Magnetfelddetektors kann dieser auch in Form eines GMR-Sensors realisiert sein (giant magnetic resistance). Derartige Sensoren weisen eine Kombination dreier Schichten auf, von denen zwei weichmagnetisch sind und eine hartmagnetisch ist.

Eine nochmalige Verbesserung der Sensitivität des Magnetfelddetektors ist dadurch möglich, daß dieser als TMR-Sensor realisiert ist (tunnelling magnetic resistance). Bei diesem ist eine hartmagnetische Schicht durch eine isolierende Schicht ersetzt.

Die Figur 2 zeigt ein Blockschaltbild eines integrierten Schaltkreises 10, welcher einen Digital/Analog-Wandler 15 enthält. Dem Eingang 11 des integrierten Schaltkreises wird das zu wandelnde digitale Signal zugeführt, welches dann vom Eingang 11 des integrierten Schaltkreises 10 über einen digitalen Signalpfad 12, 14 dem Digital/Analog-Wandler 15 zugeführt wird. Dieser stellt an seinem Ausgang ein analoges Signal zur Verfügung, welches über einen analogen Signalpfad 16 an den Ausgang 17 des integrierten Schaltkreises 10 weitergeleitet wird.

Im digitalen Signalpfad 12, 14 ist eine Vorrichtung 13 zur Potentialtrennung vorgesehen, die folglich dem Digital/Analog-Wandler 15 vorgeschaltet ist. Die Vorrichtung 13 zur Potentialtrennung selbst ist ebenso aufgebaut wie die oben im Zusammenhang mit Figur 1 beschriebene Vorrichtung 9 zur Potentialtrennung. Das am Ausgang der Vorrichtung 13 zur Potentialtrennung zur Verfügung gestellte digitale Signal, welches ein galvanisch von der Eingangsseite getrenntes digitales Signal ist, wird über den digitalen Signalpfad 14 dem Digital/Analog-Wandler 15 zugeführt. Dieser setzt das genannte Signal unter Verwendung eines digitalen Taktsignals in ein analoges Signal um, das - wie bereits oben ausgeführt wurde - über den analogen Signalpfad 16 an den Ausgang 17 des integrierten Schaltkreises weitergeleitet wird.

Das im Digital/Analog-Wandler 15 benötigte digitale Taktsignal wird außerhalb des integrierten Schaltkreises 10 erzeugt und diesem über den Anschluß 18 zugeführt. Im integrierten Schaltkreis 10 gelangt das digitale Taktsignal über die Vorrichtung 13 zur Potentialtrennung als potentialgetrenntes digitales Taktsignal an den Digital/Analog-Wandler 15. Dadurch entstehen innerhalb der Vorrichtung 13 zur Potentialtrennung zwei Übertragungskanäle, von denen einer ein Datenübertragungskanal und der andere ein Taktübertragungskanal ist.

Die Figur 3 zeigt ein Blockschaltbild eines integrierten Schaltkreises 20, welcher als Analog/Digital-Wandler einen Sigma-Delta-Wandler enthält. Dieser erzeugt einen 1-Bit-Datenstrom, dessen logischer Pegel davon abhängig ist, ob das zu wandelnde Signal größer oder kleiner als ein aufgrund dieses Vergleiches gewonnenes und anschließend integriertes Signal ist.

Dem gezeigten integrierten Schaltkreis 20 wird über den Eingang 27 ein analoges Eingangssignal zugeführt. Dieses wird vom Eingang 27 an den innerhalb der integrierten Schaltung 20 angeordneten Sigma-Delta-Wandler weitergeleitet. Dieser weist eine Subtraktionsstufe 21 auf, in welcher das über einen Rückkopplungspfad 24 zurückgeführte Signal, welches in einem Digital/Analog-Wandler 29 wieder in ein analoges Signal umgewandelt wird, vom Eingangssignal subtrahiert wird. Das Ausgangssignal der Subtrahierstufe 21 wird in einem Integrator 22 integriert und von diesem aus dem Komparator 23 zugeführt. An dessem Ausgang, der den Ausgang des Sigma-Delta-Wandlers bildet, steht als digitales Signal der bereits oben genannte 1-Bit-Datenstrom zur Verfügung.

Dieser wird - wie bereits aufgeführt - im Rückkopplungspfad 24 einer Digital/Analog-Wandlung unterworfen und als Subtrahend der Subtrahierstufe 21 zugeführt.

Weiterhin wird der 1-Bit-Datenstrom an eine Vorrichtung 25 zur Potentialtrennung geführt. Dort erfolgt - ebenso wie bei den obigen Ausführungsbeispielen - eine zweikanalige magnetische Übertragung, bei der das digitale Signal und das zur Analog/Digital-Wandlung benötigte Taktsignal potentialfrei übertragen werden. Das digitale Ausgangssignal der Vorrichtung 25 zur Potentialtrennung wird über ein digitales Filter 26, welches ebenfalls Bestandteil des integrierten Schaltkreises 20 ist, an den Ausgang 28 des integrierten Schaltkreises 20 weitergeleitet.

Auch bei diesem Ausführungsbeispiel findet in ein und demselben integrierten Schaltkreis sowohl eine Analog/Digital-Wandlung als auch eine Potentialtrennung statt. Dies führt im Vergleich zu bekannten Analog/Digital-Wandlern zu einer Einsparung von Strom, Fläche und Realisierungskosten und ermöglicht eine höhere Datenrate.

## Patentansprüche

1. Integrierter Schaltkreis, welcher einer Analog/Digital-Umsetzer oder einen Digital/Analog-Umsetzer sowie einen mit diesem verbundenen analogen und einen digitalen Signalpfad enthält, **dadurch gekennzeichnet**, daß er im digitalen Signalpfad eine Vorrichtung (9, 13, 25) zur Potentialtrennung aufweist.

2. Integrierter Schaltkreis nach Anspruch 1, **dadurch gekennzeichnet**, daß er einen eingangsseitig mit einem Eingang (4) des integrierten Schaltkreises (1) verbundenen Analog/Digital-Umsetzer (2) enthält, der an seinem Ausgang ein digitales Signal zur Verfügung stellt, daß die Vorrichtung (9) zur Potentialtrennung an den Ausgang des Analog/Digital-Umsetzers (2) angeschlossen ist und daß die Vorrichtung (9) zur Potentialtrennung mit einem Ausgang (7) des integrierten Schaltkreises (1) verbunden ist.

3. Integrierter Schaltkreis nach Anspruch 2, **dadurch gekennzeichnet**, daß der Analog/Digital-Umsetzer ein Sigma-Delta-Wandler (21, 22, 23, 24, 29) ist.

4. Integrierter Schaltkreis nach Anspruch 3, **dadurch gekennzeichnet**, daß der Sigma-Delta-Wandler eine Subtraktionsstufe (21), einen mit deren Ausgang verbundenen Integrator (22), einen mit dem Ausgang des Integrators verbundenen Komparator (23) und einen vom Ausgang des Komparators (23) ausgehenden Rückkopplungspfad (24) aufweist, in welchem ein Digital/Analog-Wandler (29) vorgesehen ist und dessen Ausgang mit der Subtraktionsstufe (21) verbunden ist, und daß die Vorrichtung (25) zur Potentialtrennung mit dem Ausgang (28) des integrierten Schaltkreises (20) verbunden ist.

5. Integrierter Schaltkreis nach einem der Ansprüche 2 bis 4, **dadurch gekennzeichnet**, daß der Ausgang der Vorrichtung (25) zur Potentialtrennung über ein digitales Filter (26) mit dem Ausgang (28) des integrierten Schaltkreises verbunden ist.

6. Integrierter Schaltkreis nach Anspruch 1, **dadurch gekennzeichnet**, daß er einen ausgangsseitig mit einem Ausgang (17) des integrierten Schaltkreises (10) verbundenen Digital/Analog-Umsetzer (15) enthält, daß die Vorrichtung (13) zur Potentialtrennung an den Eingang des Digital/Analog-Umsetzers (15) angeschlossen ist und daß die Vorrichtung (13) zur Potentialtrennung eingangsseitig mit einem Eingang (11) des integrierten Schaltkreises (10) verbunden ist.

7. Integrierter Schaltkreis nach einem der vorhergehenden Ansprüche, **dadurch gekennzeichnet**, daß die Vorrichtung (9, 13, 25) zur Potentialtrennung zwei Übertragungskanäle aufweist, von denen einer ein Datenübertragungskanal und der andere ein Taktübertragungskanal ist.

8. Integrierter Schaltkreis nach einem der vorhergehenden Ansprüche, **dadurch gekennzeichnet**, daß die Vorrichtung zur Potentialtrennung eingangsseitig eine Leiterschleife und ausgangsseitig ein Magnetfelddetektorelement aufweist.

9. Integrierter Schaltkreis nach Anspruch 8, **dadurch gekennzeichnet**, daß das Magnetfelddetektorelement ein Hallelement ist.

10. Integrierter Schaltkreis nach Anspruch 8, **dadurch gekennzeichnet**, daß Magnetfelddetektorelement ein anisotropes, magnetosensitives Element (AMR) ist.

11. Integrierter Schaltkreis nach Anspruch 8, **dadurch gekennzeichnet**, daß Magnetfelddetektorelement ein giant-magnetosensitives Element (GMR) ist.

12. Integrierter Schaltkreis nach Anspruch 8, **dadurch gekennzeichnet**, daß Magnetfelddetektorelement ein tunnel magnetoresistives Bauelement (TMR) ist.
